# EUROPEAN PATENT APPLICATION

(11) **EP 2 312 023 A2**
(43) Date of publication of application: **20.04.2011**
(21) Application number: 10187610.0
(22) Date of filing: 14.10.2010
(51) Int. Cl.: C30B 25/02, C30B 25/18, C30B 29/06, C30B 29/36

(54) **Compound single crystal and method for producing the same**

(30) Priority: 15.10.2009 JP 2009238765
(71) Applicant: Hoya Corporation, Tokyo 161-8525 (JP)
(72) Inventor: The designation of the inventor has not yet been filed
(74) Representative: von Kreisler Selting Werner

(57) **Abstract**

A method for producing a compound single crystal includes a process (I) of growing the compound single crystal while causing an anti-phase boundary and a stacking fault to equivalently occur in a <110> direction parallel to the surface, the stacking fault being attributable to the elements A and B; a process (II) of merging and annihilating the stacking fault, attributable to the element A, and the anti-phase boundary, which occurs in the process (I); a process (III) of vanishing the stacking fault attributable to the element B, which occurs in the process (I); and a process (IV) of completely merging and annihilating the anti-phase boundary. The process (IV) is carried out simultaneously with the processes (II) and (III) or after the processes (II) and (III).

## Description

### BACKGROUND

### 1. Technical Field

The present invention relates to a compound semiconductor crystal that has low defect density or little crystal lattice distortion, so that this crystal can be used as an electronic material for semiconductor devices or the like, and to a method for producing the same. More particularly, the present invention relates to a compound semiconductor crystal that has remarkably low density of structural defects on a specific surface thereof and can be preferably used as a material for power semiconductor devices capable of achieving high efficiency and enduring high voltage, and a method for producing the same.

### 2. Related Art

Silicon carbide (SiC) or gallium nitride (GaN) is beginning to be used as a compound semiconductor crystal that forms a substrate of high-functionality semiconductor devices.

Crystal defects included in the compound semiconductor crystal have a significant effect on the performance of resultant semiconductor devices. For example, structural defects, such as anti-phase boundaries or stacking faults, cause current leakage or dielectric breakdown, thereby significantly damaging the performance of a power semiconductor device. Therefore, in compound semiconductor crystals used for substrates of semiconductor devices, it is desirable to reduce the density of structural defects.

As methods for growing a SiC single crystal, bulk growth using a sublimation method and the formation of a thin film through epitaxial growth on a substrate and the like are known conventionally. In the case of bulk crystal using the sublimation method, it is possible to grow a hexagonal (6H, 4H, and the like) SiC single crystals thoes are higher-temperature phase polytypes, and to form a single crystal substrate made only of SiC. However, too many defects (particularly, micropipes) are introduced into the crystal, and it is difficult to increase the diameter of the substrate.

In contrast, when an epitaxial growth method is used over a single crystal substrate, it is possible to realize improvement in the controllability of impurity doping concentration and an increase in the diameter of the substrate and to eliminate the micropipes, which are problematic in the sublimation method. However, in the epitaxial growth method, an increase in the density of stacking faults due to a difference in the lattice constant of the substrate and SiC often becomes a problem. In particular, while silicon is most generally used for a substrate on which growth is employed, the lattice mismatch between silicon and SiC exceeds the tolerance of elastic deformation. Thus, anti-phase boundaries (APB) or stacking faults (SF) significantly occur in a growth layer of a SiC single crystal, and when a semiconductor device is constructed, become one of sources of a leakage current, thereby impairing the characteristics of SiC for an electronic device. That is, when SiC is grown over a (001) silicon single crystal substrate using the epitaxial growth method, both the position and direction of the APB or the SF occurring on the substrate are random. In addition, the generated APB or SF does not disappear but remains even if the film thickness increases.

As a method for efficiently reducing the APB, a method of growing SiC over a silicon single crystal substrate, in which the surface normal axis of a (001) silicon single crystal is slightly tilted from a <001> direction to a <110> direction (an off angle is introduced), was proposed by K. Shibahara et. al (see Applied Phys. Lett., 50 (1987), pp. 1888-1890). In addition, as an application of Applied Phys. Lett., 50 (1987), pp. 1888-1890, the present applicant proposed a technology for reducing the APB, which propagates inside a SiC single crystal layer, by epitaxially growing the silicon SiC single crystal layer over a substrate that has undulations extending in parallel in one direction over the surface of a silicon substrate (Japanese Patent No.3576432).

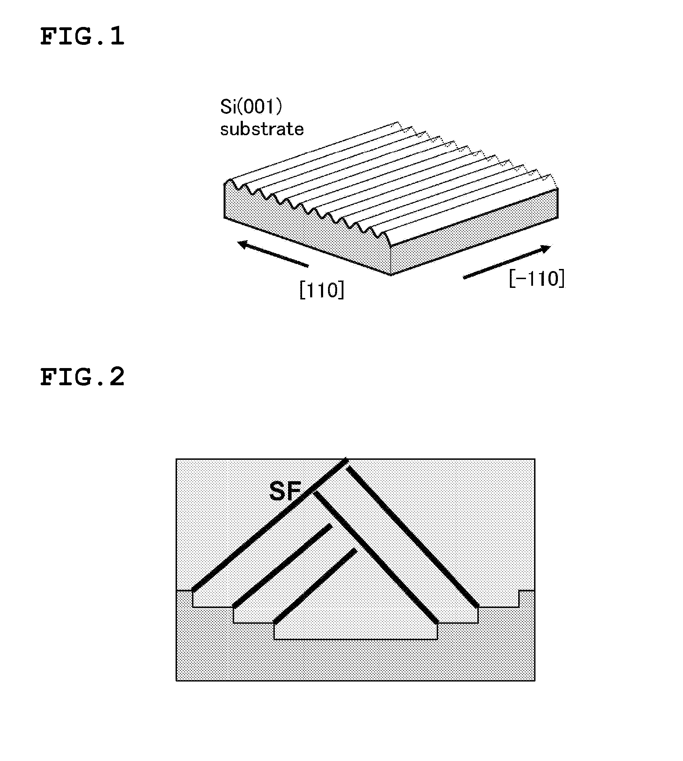

Fig. 1 schematically shows an example of a substrate that has undulations extending in parallel in one direction. In the Si substrate of Fig. 1, slopes of respective undulations formed on the Si (001) substrate confront each other, and a microscopic structure of each slope includes a terrace (that is, a planar section) and an atomic-level height step (that is., a stepped section). Since the atomic-level steps are introduced at regular intervals in one direction due to the slopes of the undulations, a vapor deposition method causes epitaxial growth due to a step flow, and has an effect that reduces planar defects from propagating in the direction orthogonal to the introduced steps (that is, the direction perpendicular to the steps, that is, the direction in which the undulations extend). (That is, among anti-phase areas in two orthogonal directions, which are included in the film, with respect to an increase in the film thickness of the SiC single crystal layer, one anti-phase area, which extends in the direction parallel to the introduced steps, extends prior to the other anti-phase area, which extends in the direction orthogonal to the steps.) In addition, since the undulated slopes confront each other, the anti-phase areas, which extend in the direction parallel to the steps, propagate to close each other as the film thickness increases, and the APB is finally merged and annihilated (Fig. 2).

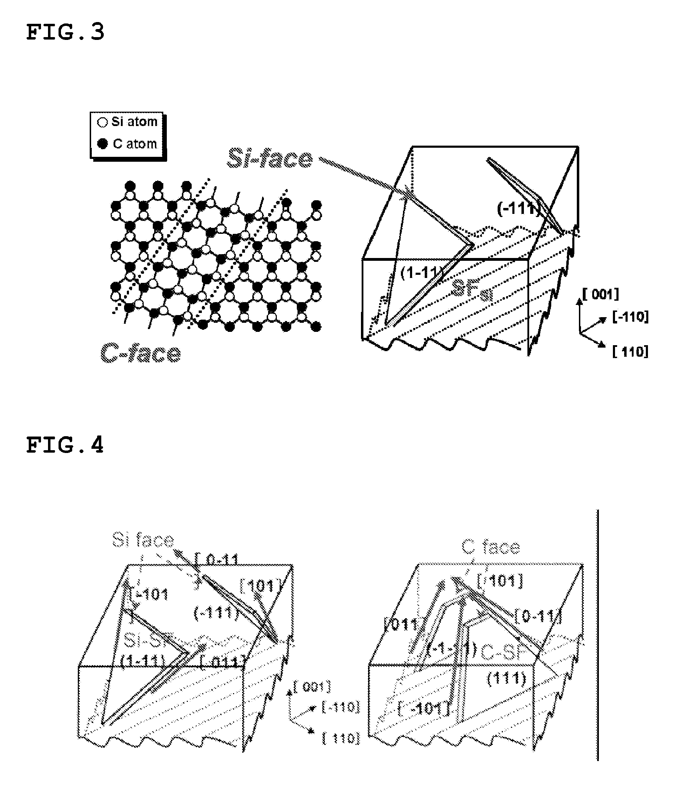

In addition, the present applicant proposed a technology for reducing stacking faults (SF) that propagate inside a SiC single crystal layer (Japanese Patent No.3761418). This is also referred to as a Switch Back Epitaxy (SBE) method, and is based on the fact that, with respect to two types of polarities of the SF propagating inside the SiC single crystal layer, (1) the respective polarity surfaces are in an opposing relationship and (2) the growth rates of the respective polarity surfaces are different due to surface energies. As shown in Fig. 3, in the SF in which its Si polarity surface is exposed (hereinafter, referred to as Si-SF), the exposed surface in the back side of the substrate is the C polarity surface. As a result of SiC growth, the Si polarity surface extends and propagates, whereas the C polarity surface is vanished and annihilated. So, in order to annihilate the Si-SF, which continuously propagates on the substrate, 3C-SiC is homoepitaxially grown on the reverse surface side of the Si-SF. This completely eliminates the SF.

However, according to the studies of the present inventors, it has been proved that the methods of Japanese Patent No.3576432 and Japanese Patent No.3761418 do not completely remove the defects although they decrease the defect density.

The inventors surmised, as the result of investigation performed investigation into the reason, that new SFs sporadically generated during the process of growing a SiC single crystal layer. In addition, a factor leading to the occurrence of the new SFs was thought to be distortion between the 3C-SiC substrate in the SBE and the SiC homoepitaxial layer and/or inside the SiC homoepitaxial layer. The inventors thought that thermal distortion due to temperature distribution inside the substrate surface, distortion following lattice matching when the SFs are merged and annihilated, or distortion due to a difference in the thermal expansion coefficients between SiC and silicon would take place during the growth of the SiC single crystal layer, and that the new SFs occur inside the SiC single crystal in order to alleviate such distortion.

Based on this assumption, it is necessary to remove distortion that occurs during the growth of a compound semiconductor crystal in order to fabricate a compound semiconductor crystal substrate having low defect density, which is suitable for the fabrication of devices.

### SUMMARY

An advantage of some aspects of the invention is to provide a compound semiconductor crystal substrate having low defect density, which can provide a new improvement for reducing defects and be applied to semiconductor devices, and a method for producing the same.

The inventors made a study intensively on the problems of the related art in order to produce a SiC single crystal, in which SF and APB are remarkably reduced.

First, the SF was investigated. Two types of SFs include SF in which C polarity is exposed (hereinafter, referred to as C-SF) and Si-SF. Due to the difference in surface energy between the SF and a SiC (001) plane, the Si-SF expands but the C-SF shrinks and vanishes as the thickness of the SiC-grown film increases. It was also proved that SF is annihilated through the merger of SFs and the merger of SF and the APB (in some cases, is partially annihilated).

In addition, as a method for efficiently removing the APB, it was proved that the Si-SF and the C-SF, which occur along with the growth of SiC over the substrate of Fig. 1, are anisotropic. This is caused by "a step flow growing method," which is the starting point of the growing method using Fig. 1. It was proved that the polarities of the SFs, each of which occurs parallel to the direction parallel to the steps and to the direction orthogonal to the steps (that is, the direction in which the undulations extend), are unified (in other words, if the direction of the step flow is one direction, an anisotropy exists in the direction in which an SF extends for every SF polarity) (Fig. 4). Here, as described above, according to their characteristics, the C-SF vanishes, and the Si-SF expands and propagates insofar as it is not merged. Therefore, as the result of the epitaxial growth of SiC over the substrate in which the undulations extend only in one direction as shown in Fig. 1, a SiC film was formed, in which the C-SF did not remain but only the Si-SF remained in one direction. In addition, the APB was completely annihilated due to the slopes of the undulations, which confront each other.

The inventors surmised that the situation in which the SF is annihilated only in one direction and/or remains only in one direction has an effect on the "distortion" inside the SiC film and this distortion causes the SF, which was originally supposed to be annihilated, to occur again. This is proved from the remaining of the C-SF, which is supposed to vanish with increasing in the film thickness. That is, it was though that, as in the case using the substrate of Fig. 1, if directional the anisotropy of the polarity of the SF, which exists in the early stage of the growth of SiC, or the directional anisotropy of the polarity of the SF, which remains along with an increase in the thickness of the SiC-grown film, is high, stress has a directional anisotropy and, as a result, it becomes difficult to efficiently reduce the SF, which exists (is exposed) on the surface of the SiC substrate (in the latter stage of the growth of SiC).

As a method for reducing the directional anisotropy of the polarity of the SF, a method of growing SiC over an unprocessed Si (001) substrate (hereinafter, referred to as a "just substrate") is considered. As supposed above, when SiC was grown to a sufficient film thickness over the just substrate, a SiC film was formed, in which the Si-SF remained not only in one direction but also randomly in the orthogonal direction. However, unlike the growth over the substrate of Fig. 1, few APBs decreased but a number of the APBs still remained although the thickness of the SiC-grown film increased.

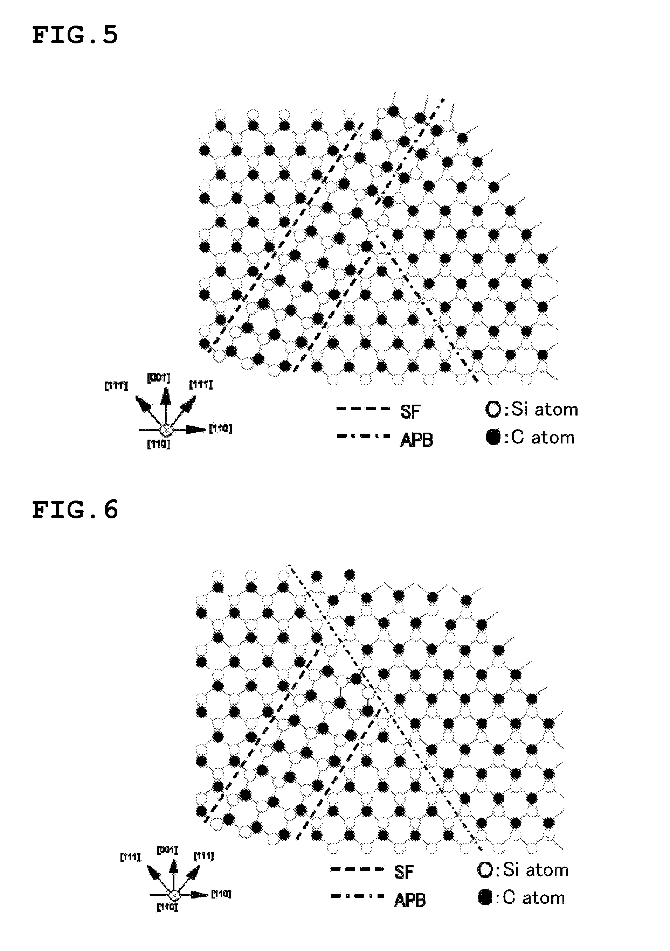

In addition, with reference to Figs. 5 and 6, a description will be given of the APB that obstructs Si-SF propagation. The APB existing inside 3C-SiC consistes of Si-Si bonds only. In the case where the SF propagates across the APB, a new APB must be created by the bonding of only C atoms, as shown in Fig. 5. The APB, in which only C atoms are bonded, has higher formation energy and does not exist in SiC. At the junction with SF and APB, as shown in Fig. 6, a dangling bond is formed to stabilize the crystal, and as a result, the propagation of the SF is terminated.

Through the above-described investigation, the inventors have made the following constructs. The following constructs relate to SiC, in which the anisotropy of the polarity of a generating SF is reduced in the direction of propagation, and to SiC, in which both the SF and the APB are effectively reduced by intentionally arranging the APB in a film, in which the APB would otherwise be completely degrade device performances. Herein, "the intentionally arranged APB" refers to an APB, which is supposed to annihilate a Si-SF by being merged with the Si-SF, which is not vanishing, unlike a C-SF, and finally, to an APB, which is created so that the APBs can be annihilated by being merged together.

That is, the invention provides the following constructs:

### (Construct 1)

A method for producing a compound single crystal composed of two types of elements, which include element A and element B, in which the compound single crystal is epitaxially grown over a single crystal substrate having a cubic {001} plane as a surface thereof, the method including:
a process (I) of growing the compound single crystal while causing a stacking fault to equivalently occur in a <110> direction parallel to the surface, the stacking fault being attributable to an anti-phase boundary and the elements A and B;
a process (II) of merging and annihilating the stacking fault, which occur in the process (I), attributable to the element A, and the anti-phase boundary;
a process (III) of vanishing the stacking fault, which occurs in the process (I), attributable to the element B,; and
a process (IV) of completely merging and annihilating the anti-phase boundary,
in which the process (IV) is carried out simultaneously with the processes (II) and (III) or after the processes (II) and (III).

### (Construct 2)

The method for producing a compound single crystal according to Construct 1, in which the process (I) epitaxially grows the compound single crystal over the single crystal substrate, in which the single crystal substrate is a substrate that has, over a surface thereof, a region in which a plurality of undulations extending in parallel in a [110] direction is formed, and a region, in which a plurality of undulations extending in parallel in [-110] direction is formed, in which both side surfaces of the undulations have a slope-shape.

### (Construct 3)

The method for producing a compound single crystal according to Construct 2, in which the processes (II) and (III) are an epitaxial growth process over the undulations.

### (Construct 4)

The method for producing a compound single crystal according to Construct 2 or 3, in which the process (IV) preferentially grows the undulation in a direction parallel or orthogonal to the extending direction thereof in each of the regions, by varying the source ratio of the elements A and B.

### (Construct 5)

The method for producing a compound single crystal according to Construct 1, in which the processes (I), (II) and (III) are an epitaxial growth process over an unprocessed {001} plane, in which the process (IV) forms a plurality of undulations that extends in parallel in a [110] direction on a surface that is obtained in the processes (I) to (III), both side surfaces of the undulations having slope-shape, and epitaxially grows the compound single crystal over the undulations.

### (Construct 6)

A method for producing a compound single crystal, in which the compound single crystal is epitaxially grown over a single crystal substrate having a cubic {001} plane as a surface thereof, the method including:
a process of alternately preparing a region A and a region B over an entire surface of an effective area of the substrate, in which the region A is formed with a plurality of undulations extending in parallel in one direction, and the region B is formed with a plurality of undulations extending in a direction orthogonal to the extending direction thereof; and
a process of epitaxially growing the compound single crystal over the substrate having the region A and the region B,
in which both side surfaces of the undulations have a slope shape.

### (Construct 7)

The method for producing a compound single crystal according to Construct 6, in which the process of epitaxially growing includes a process of preferentially growing the undulations in a direction parallel or orthogonal to the extending direction thereof in each of the regions by varying a source ratio.

### (Construct 8)

The method for producing a compound single crystal according to Construct 6 or 7, in which the region A has a surface area that is substantially equal to that of the region B in a surface of the substrate.

### (Construct 9)

A method for producing a compound single crystal, in which the compound single crystal is epitaxially grown over a single crystal substrate having a cubic {001} plane as a surface thereof, the method including:
a process of epitaxially growing the compound single crystal over an unprocessed {001} plane as the substrate;
a process of forming a plurality of undulations that extends in parallel in the [110] direction on a surface of the compound single crystal obtained in the epitaxial growth process; and
a process of epitaxially growing a compound single crystal over the undulations.

### (Construct 10)

The method for producing a compound single crystal according to any one of Constructs 2 to 9, in which the undulations are formed such that an angle defining with the substrate is from 2° to 55° and slopes of the undulations are opposite to each other.

### (Construct 11)

The method for producing a compound single crystal according to any one of Constructs 1 to 10, in which the stacking fault remaining on the {001} plane, which is the top surface, has a single polarity, and substantially equivalently exists in the <110> direction on an entire surface of the {001} plane.

### (Construct 12)

The method for producing a compound single crystal according to any one of Constructs 1 to 11, in which the substrate is a cubic Si substrate or a cubic SiC substrate, and the compound single crystal is a cubic SiC crystal.

### (Construct 13)

A compound single crystal composed of two types of elements, which include element A and element B, including two types of crystal growth regions,
in which the two types of crystal growth regions are formed alternately for each type, in a direction orthogonal to the crystal growth direction,
in which a stacking fault A-SF, at which the polarity of the element A exposes, and a stacking fault B-SF, at which the polarity of the element B exposes, exist inside the crystal,
in which only the fault A-SF of the faults exists on a specific {001} plane, and the fault A-SF on the specific {001} plane exists extending in a <110> direction over an entire surface of the {001} plane, the fault A-SF being statistically equivalent,
in which, in the two types of crystal growth regions, propagation orientations of the two types of the stacking faults are limited to different planes in each of the crystal growth regions,
in which the propagation orientation of a planar defect in one of the crystal growth regions is an orientation that is produced by orthogonally converting the propagation orientation of the two types of the stacking faults in the other one of the crystal growth regions while maintaining the propagation orientation parallel to the specific {001} plane,
in which, in a cross section of a portion defined by the two types of crystal growth regions in a direction, in which the two types of crystal growth regions are formed alternately, no anti-phase boundaries (APBs) appear in one of the crystal growth regions and APBs appear or are merged and annihilated in the other one of the crystal growth regions, and
in which APBs are annihilated on the top surface of the crystal.

### (Construct 14)

The compound single crystal according to Construct 13, in which the compound crystal is cubic, with a bottom surface thereof being a (001) plane,
in which the two types of crystal regions are formed alternately for each type, toward at least one of the [110] orientation and the [-110] orientation,
in which polar sections in the top surface of the compound crystal are formed in a direction that alternates with the [110] orientation and the [-110] orientation in each of the two types of crystal growth regions, and
an area ratio between the two types of crystal growth regions in the surface of the compound crystal is 3:7 to 7:3.

### (Construct 15)

A compound single crystal composed of two types of elements, which include element A and element B,
in which a stacking fault A-SF, at which the polarity of the element A exposes, a stacking fault B-SF, at which the polarity of the element B exposes, and an anti-phase boundary (APB) exist inside the crystal,
in which all APB are merged and annihilated, and
in which only the fault A-SF of the faults exists in a specific {001} plane, and the fault A-SF on the specific {001} plane exists extending in a <110> direction over an entire surface of the {001} plane, the fault A-SF being statistically equivalent.

### (Construct 16)

The compound single crystal according to any one of Constructs 13 to 15, in which the compound crystal is cubic SiC.

### (Construct 17)

The compound single crystal according to Construct 16, in which the element A is silicon, and the element B is carbon.

### (Construct 18)

The compound single crystal according to any one of Constructs 13 to 17, the compound single crystal having a film or plate-like configuration, a degree of warpage in the {001} plane is substantially equal in the <110> direction inside the plane.

According to the above-described constructs, it becomes possible to realize a compound crystal substrate, which can reduce the density of structural defects and be applied to a power semiconductor device material having high efficiency and capable of enduring high voltage, and a method for producing the same.

### BRIEF DESCRIPTION OF THE DRAWINGS

Fig. 1 is a schematic view of a substrate that has undulations extending in parallel in one direction.
Fig. 2 is a schematic cross-sectional view showing a mechanism that merges and annihilates a planar defect attributable to an increase in the thickness of a grown film.
Fig. 3 is a view showing the structure of an SF in 3C-SiC.
Fig. 4 is a view showing the structure of an SF in 3C-SiC.
Fig. 5 is a view illustrating a mechanism that annihilates an SF.
Fig. 6 is a view illustrating a mechanism that annihilates an SF.
Fig. 7 is a schematic view showing the surface and cross-sectional shape of a substrate used in an embodiment of the invention.
Fig. 8 is a schematic view showing a crystal surface that illustrates an embodiment of the invention.
Fig. 9 is a schematic view of a substrate used in an embodiment of the invention.
Fig. 10 is a view showing the dependence of x values on film thickness in Example 1.
Fig. 11 is a view showing the dependence of Si-SF density on film thickness in Example 1.
Fig. 12 is a view showing the dependence of C-SF density on film thickness in Example 1.
Fig. 13 is a view showing the dependence of x values on film thickness in Comparative Example 1.
Fig. 14 is a view showing the dependence of Si-SF density on film thickness in Comparative Example 1.
Fig. 15 is a view showing the dependence of C-SF density on film thickness in Comparative Example 1.
Fig. 16 is a view showing the dependence of x values on film thickness in Example 3.

### DESCRIPTION OF EXEMPLARY EMBODIMENTS

Hereinafter, embodiments of the present invention are described.

### <Embodiment 1>

As for Embodiment 1, a description is given of a cubic compound single crystal composed of two types of elements, including element A and element B. The compound single crystal is a plate like crystal, of which the main surface (that is, one surface of crystal surfaces, which exposes the largest area) is parallel to a (001) plane, and the back surface is parallel to the main surface (that is, the back surface is parallel to the (001) plane). The density of APBs included in the inside of the crystal continuously decreases across from the back surface to the main surface. Herein, the term APB can be explained as "the boundary between regions at which the stacking orders of the elements A and B are reversed." The crystal structures of the regions, which are on both sides of the APB, are rotated 90° with respect to each other about a [001] orientation serving as the axis.

Inside the crystal, the ratio of the APBs (in a surface parallel to the main surface) is quantified using the (001) plane as an intercept. Here, if the area ratio of a region composed of the element A, in which the surface of polarity is oriented in a (111) plane and a (-1-11) plane, is set to be x, where 0≤x≤1, the area ratio of a region composed of the element B, in which the surface of polarity is oriented in the (111) plane and the (-1-11) plane, is expressed by 1-x. In addition, the value of x is from 0.3 to 0.7 (preferably, 0.5) at the rear side (corresponding to the earlier stage in the growth of the film), and is 1 or 0 on the top surface of the substrate (corresponding to the latter stage in the growth of the film).

In other words, this indicates a compound single crystal in which a number of equivalent APBs exist inside the crystal, independent of the polarity, but the APB on the top surface of the substrate is removed.

In addition, the ratio of the SF inside the crystal (in a surface parallel to the main surface) is quantified using the (001) plane as an intercept. In this case, if the ratio of the number of SFs (hereinafter, referred to as A-SFs), which have a polarity surface composed of the element A and are oriented in a (111) plane and a (-1-11) plane, is set to be y(a), where 0≤y(a)≤1, the ratio of the number of the A-SFs, which are oriented in a (-111) plane and a (1-11) plane, is expressed by 1-y (a) . Likewise, if the ratio of the number of SFs (hereinafter, referred to as B-SFs) , which have a polarity surface composed of the element B and are oriented in the (111) plane and the (-1-11) plane, is set to be y (b) , where 0≤y(b)≤1, the ratio of the number of the B-SFs, which are oriented in the (-111) plane and the (1-11) plane, is expressed by 1-y(b) . In addition, both the values of y(a) and y(b) are from 0.3 to 0.7 (preferably, 0.5) on the top surface of the substrate at the rear side. However, only the A-SF exists on the top surface of the substrate, but the B-SF is substantially annihilated.

In other words, this indicates a compound single crystal in which the equivalent SFs exist inside the crystal, independent of the polarity (A-SF, B-SF) or the orientation, but only one polarity of equivalent SF (A-SF) exists on the top surface of the substrate, independent of the orientation. In addition, the term "the equivalent SFs, which exist independent of the direction" refers to the SF, which propagates parallel to four equivalent {111} surfaces (specifically, (111) plane, (-1-11) plane, (-111) plane, and (1-11) plane), and extends in four equivalent <110> directions (specifically, [110] orientation, [-1-10] orientation, [-110] orientation, and [1-10] orientation) at a single (001) intercept.

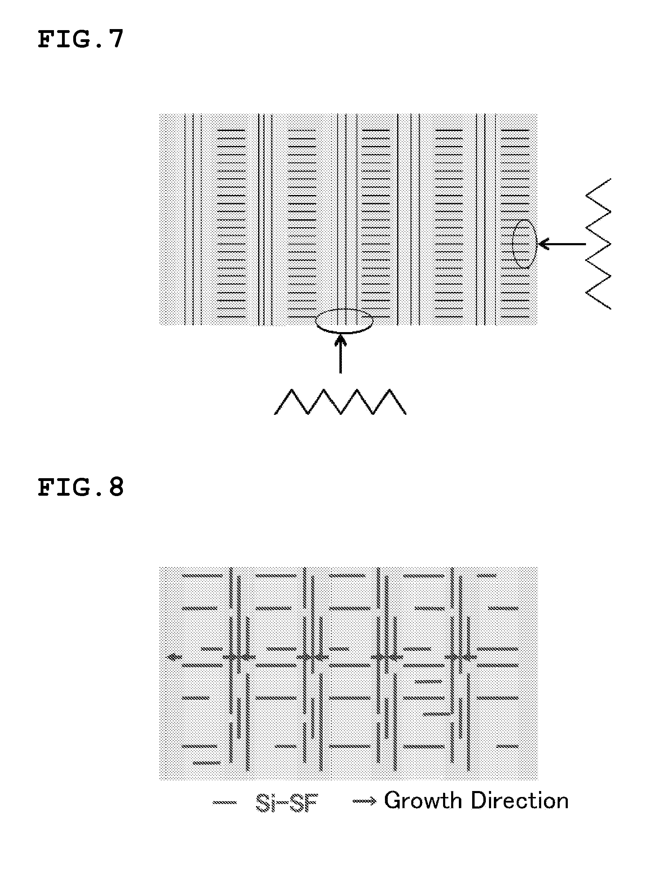

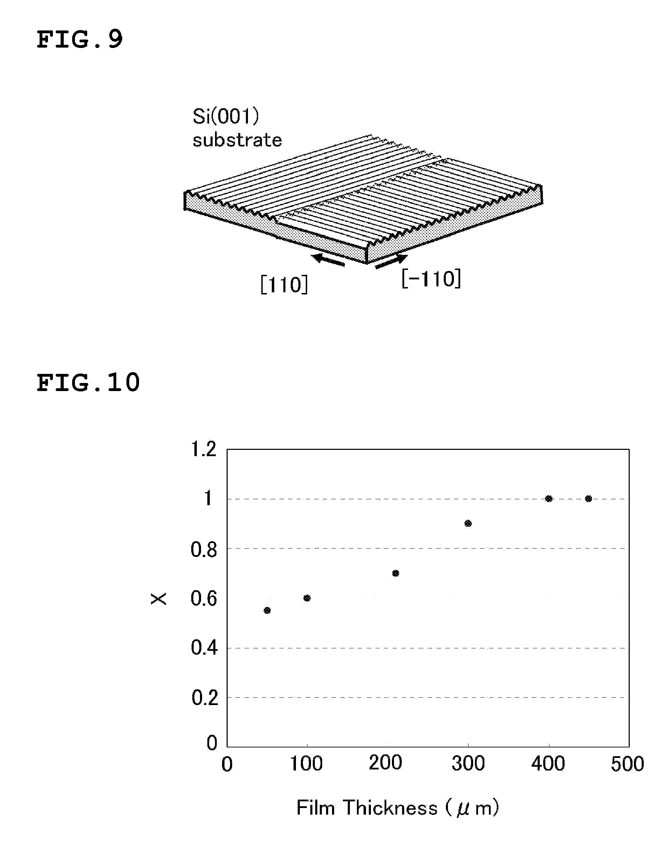

As an example for realizing this embodiment, the following methods can be considered. Two types of crystal growth regions are formed over a (001) substrate (herein, a description will be given of a substrate made of Si or SiC). Specifically, slopes having ridges parallel to a [110] orientation (including a [-1-10] orientation) and a [-110] orientation (including a [1-10] orientation), respectively, are formed (see, for example, Figs. 7 and 9). The maximum inclination of the slopes is from 2° to 90°, and the cross-sectional shapes of adjacent undulations are continued. That is, although some portions in the boundaries between the adjacent undulations (that is, the valleys of the undulations) and the peaks of the undulations have an inclination of 0°, the inclination continuously changes from 0° to the maximum inclination from this portion toward the slope. Thereby, microscopic steps and terraces are formed on the slope. If the maximum inclination is less than 2°, the step at the atomic level height, which is supposed to realize a polarity surface, becomes too small compared to the area of the terrace, which is a non-polarity plane (a (001) plane), and thus it becomes impossible to intentionally manipulate the density of the APB. In addition, if the maximum inclination exceeds 90°, the cross-sectional shape of the undulations becomes an overhang shape, thereby obstructing the growth of the single crystal. It is preferable that the maximum inclination is smaller than the angle (substantially, 55°) defined between the substrate and the (111) plane.

If the APB suddenly decreases along with the growth, the SF is likely to recur due to residual distortion inside the crystal or the like if the growth follows the annihilaion of the APB. Therefore, in order to maximize the effect of the annihilation of the SF, it is preferable to annihilate the APB in the vicinity of the surface by gradually decreasing the density of the APB along with the increase in the thickness of the grown film. However, if the size and position of a crystal region surrounded by the APB (that is, an Anti Phase Domain (APD)) are random, it is difficult to annihilate the APD by growing the crystal. The elimination of the APBs is realized by the size and arrangement of the APD and by growing the APD in their growth direction. Through the growth over the substrate as shown in Fig. 7, two types of crystal regions having different aligning orientations can be arranged on the stripes as shown in Fig. 8. It is possible to annihilate the APD by selectively growing one of the crystal regions in the transverse direction (for example, by adjusting growth conditions).

The area ratio of a processing region (that is, a first type of crystal growth region) in which the ridges of the undulations are along the [110] orientation to a processing region (that is, a second type of crystal growth region) in which the ridges of the undulations are along the [-110] orientation is in the range from 7:3 to 3:7 and, preferably, 1:1. In addition, it is preferable that both the processing regions are mixed as much as possible. More preferably, the processing regions are stripe areas that extend along the longer side in a [110] orientation and are alternately arranged over the entire surface with a width from 1 µm to 1mm.

A compound semiconductor crystal, which maximizes the effect of the invention, is grown over the substrate. Herein, a description is given of SiC as the compound semiconductor crystal.

Although Chemical Vapor Deposition (CVD), Molecular Beam Epitaxy (MBE), Liquid Phase Epitaxy (LPE), and the like can be used to grow SiC, it is preferable to separately adjust the supplied amount of Si source and the supplied amount of C source, and vary the ratio of the Si source to the C source by precisely adjusting the flow rates of the Si and C sources in the form of gases.

For example, in the case of thermal CVD, the ratio between the Si source supplied and the C source supplied is gradually changed from a growth start point to a growth finish point. In this case, the growth rate of the C polarity surface becomes higher as the amount of the Si source is increasingly supplied, and the growth rate of the Si polarity surface becomes higher as the C source is supplied more. Therefore, by the selection of conditions, in which the growth rate of the Si surface and the growth rate of the C surface become the same level, in the early stage of the growth, it is possible to form an APB distribution (x=0.3 to 0.7) according to the area ratio between the processing region, in which the ridges of the undulations are along the [110] orientation, and the processing region, in which the ridges of the undulations are along the [-110] orientation. In this case, in the (001) plane parallel to the growth surface, the film is grown by exposing the C-SF in the direction parallel to the ridges and the Si-SF in the direction orthogonal to the ridges. As the thickness of the grown film increases, the C-SF propagates while shrinking, thereby annihilating itself.

In addition, in response to the growth, the ratio of supplying the Si source and the ratio of supplying the C source can be varied during the growth so that, for example, the C source is increasingly supplied (to be C rich). Thereby, it is possible to set the growth rate of the Si surface to exceed the growth rate of the C surface and x in the APB distribution to approach to 1 early. In the meantime, it is possible to set the growth rate of the C surface to exceed the growth rate of the Si surface and x in the APB to approach to 0 early by varying the ratio of the Si source and the ratio of the C source during the growth so that the Si source can be supplied more (to be Si rich). Thereby, Embodiment 1 of the invention is realized.

As in Embodiment 1, in the case of SiC growth, the two types of the crystal growth regions are grown over the undulations (including the undulation that extends in the [110] orientation and the undulation that extends in the [-110] orientation), which are orthogonal to each other on the (001) plane that acts as the growth surface. Here, the propagation orientation of the planar defect in each growth region is converted at 90° while being parallel to the (001) plane.

In addition, for example, when the cross section of the SiC crystal, which is grown over the substrate of Fig. 9, is seen in the [110] or [-110] orientation, the APB does not appear in one crystal growth region (that is, the cross section parallel to the direction in which the undulation extends) but appears in the other crystal growth region (that is, the cross section orthogonal to the direction in which the undulation extends). In addition, the APB comes to be merged and annihilated.

### <Embodiment 2>

A description will be given of Embodiment 2 that uses a different type in order to realize the same type of compound single crystal as that of Embodiment 1.

As an example of the method for realizing this embodiment, the following method can be considered. A compound semiconductor crystal (herein, it is assumed to be made of SiC) is grown over a (001) substrate (herein, it is assumed to be made of Si or SiC) without forming undulations. Thereby, it is possible to produce a SiC crystal, in which a number of equivalent APBs and a number of equivalent SFs exist without depending on either polarity (Si polarity, C polarity) or orientation. Here, unlike the SiC of Embodiment 1, which is formed over the substrate in which the slopes of the undulations are opposite each other, the APBs are not merged or annihilated. As for the SF, the C-SF annihilates itself, and the Si-SF decreases in number through the merger of the SFs themselves or with APB, in response to the increase in the thickness of the grown film.

After the growth of SiC up to about 50µm, undulations extending in one direction are formed over the surface of the SiC. In the SiC having a film thickness of 50µm, a decrease in the density of the APB is substantially saturated. Slopes having ridges, which are parallel to the [110] orientation (including [-1-10] orientation) or the [-110] orientation (including [1-10] orientation), are formed over the surface of the SiC. The inclination or the shape of the slopes is the same as in Embodiment 1.

A SiC crystal is additionally grown over the SiC crystal, which is formed to have the undulations as above. Here, the main object is to annihilate the APB by merging it. Therefore, in order to efficiently remove the APB (in order to approach x to 0 or 1 early), it is preferable to control the supply ratios of the Si source and the C source in the same way as in Embodiment 1.

In addition, although the undulations extending only in one direction are formed in Embodiment 2, it is apparent according to the principle of the invention that the same effect can be obtained by forming the undulations in two directions as in Embodiment 1.

As described above, the two embodiments are a method for producing the intended low defect compound semiconductor crystal, and can be regarded to satisfy the following:
1) equivalently creating SF without depending on either polarity or orientation in the early stage of the growth of the film; and
2) intentionally creating APB and annihilating the generated APBs in the surface of the substrate (in the latter stage of the growth of the film)

The above item 1) is a feature based on the fact that annihilating processes are different according to polarity. A means for realizing this can set the growth rates of the film in the growing surface to be macroscopically equivalent over the entire surface of the substrate in directions corresponding to (111), (-1-1-1), (-111), and (1-11) orientations. This is because there is correlation between the growth direction and the SF polarity. Thereby, the polarities of the SF in four directions become substantially equivalent. Among them, even if the C-SF annihilates itself in response to an increase in the thickness of the grown film, the Si-SF exists equivalently in the four directions.

The above item 2) is a feature that is performed to merge and annihilate the SFs, which are not annihilated by themselves in the item 1), and is based on the fact that the APBs are merged and annihilated when they are brought to oppose each other. A means for realizing this to form opposite slopes in order to merge and annihilate the APB, and/or control the ratios of supplying the Si source and the C source. By the control of the ratios of supplying the sources, it is possible to grow a specific plane (for example, only {111} planes parallel in the direction, in which the undulations extend, or only {111} planes parallel to the direction of the steps) prior to other planes in the compound semiconductor crystal (C plane flow growth or Si plane flow growth). Through such preferential growth, it is possible to efficiently (early) realize the merger and annihilation of the APB.

The foregoing two types of compound semiconductor crystals do not have a directional anisotropy in the degree of warpage inside the substrate and in the surface of the substrate. Therefore, it is possible to fabricate a compound semiconductor crystal without creating new SF while growing a film and, as a result, produce a low-defect compound semiconductor crystal.

### [Examples]

Below, the invention is described in more detail by way of Examples.

### (Example 1)

Undulations extending substantially in the [110] direction were formed over the entire surface of a Si (001) substrate having a diameter of 4 inches by rubbing polishing particles against the surface of the substrate to be parallel in the [110] direction (introduction of polishing scratches in one direction). Afterwards, the same process was carried out in the [-110] direction (introduction of polishing scratches in orthogonal direction). Here, the process of introducing the orthogonal polishing scratches was discontinuous and used stripe areas having intervals of about 0.6mm. This, as a result, formed a surface, in which the stripe areas having parallel polishing scratches applied in the [110] direction and the stripe areas having parallel polishing scratches applied in the [-110] direction are alternately arranged with the intervals of 0.6mm. The long edge of each stripe area is parallel to the [-110] direction. Figs. 7 and 9 are schematic views showing the surface of the resultant substrates to which the polishing scratches were introduced.

Here, the process of introducing polishing scratches in one direction formed a number of polishing scratches, which are substantially in parallel, by rubbing a polishing agent in a predetermined direction while permeating a polishing cloth (Engis M414) with the polishing agent. The polishing agent used herein was diamond slurry (Hyprez manufactured by Engis Corporation) that has a particle diameter of about 9µm. Here, the pressure was 0.2 kg/cm², and the cloth was reciprocated about 300 times in order to introduce the polishing scratches a single time (polishing in one direction).

Since diamond particles or the like were attached to the surface of the Si (001) substrate to which the polishing process was performed to be parallel in the [110] direction and the [-110] direction, the substrate was cleaned using an ultrasonic cleaner, followed by cleaning using a solution, in which hydrogen peroxide solution and sulfuric acid are mixed (1:1), and an hydrofluoric acid solution. After the cleaning, a thermal oxide film was formed over the substrate, to which the undulation process was performed, at a thickness of about 0.5µm using a heat treatment device. The formed thermal oxide film was removed using diluted hydrofluoric acid. The cross section of the resultant area, to which the undulation process was performed, was in the form of continuous waves, and the parallel undulations in the [110] orientation or the [-110] orientation were always in the continuous state. Referring to the cross-sectional shape of the undulations, the size of the wave-like concaves and convexes was irregular, but the density of the undulations was high and the undulations were always continuity. The ridge-valley height of the undulations was about 30nm to 50nm, the period of the undulations was about 1µm to 2µm, and the angle of inclination of the slopes of the undulations was about 3° to 5°.

An ultra-thin SiC layer was formed by heating the Si (001) substrate having the stripe-like perpendicular to undulation areas, which were produced as above, inside a CVD system in a mixed atmosphere of acetylene (C₂H₂) and hydrogen. Here, the substrate was heated up to 1350°C. A source gas and a carrier gas, acetylene and hydrogen respectively, were supplied to the surface of the substrate from room temperature. The amounts supplied and the pressure are presented in Table 1.

**[Table 1]**

| Ramping up conditions of substrate in Example 1 | |
|---|---|
| Amount of C₂H₂ supplied | 30cc/min |
| Amount of H₂ supplied | 100cc/min |
| Pressure | 20Pa |

After the surface temperature reached 1350°C, the substrate was kept in the atmosphere of Table 1 for 15 minutes. After the ultra-thin SiC layer was formed in the above method, the SiC layer was grown by supplying dichlorosilane, acetylene, and hydrogen at 1350°C. The SiC growth conditions are presented in Table 2.

The pressure during the growth of SiC was adjusted using a pressure-adjusting valve, which was installed between a reaction chamber and a pump. The growing of SiC was carried out for 8 hours in the conditions of Table 2, and 3C-SiC was grown at 450µm over the Si substrate. Fig. 10 shows the dependence of x values on the thickness of the grown film in Example 1.

**[Table 2]**

| SiC growth conditions in Example 1 | |
|---|---|
| Amount of Si₂H₂Cl₂ supplied | 50cc/min |
| Amount of C₂H₂ supplied | 10cc/min |
| Amount of H₂ supplied | 100cc/min |
| Pressure | 40Pa |

After the growth of 3C-SiC, a single 3C-SiC substrate was fabricated by removing the Si substrate by eching using a mixed acid of hydrofluoric acid and nitric acid.

The shape of the resultant 3C-SiC substrate was measured, in which the radius of curvature in the direction parallel to the [-110] orientation was about 20m and that of curvature in the direction parallel to the [110] orientation was about 22m. That is, in the 3C-SiC substrate produced in Example 1, no difference in the radii of curvature between the [-110] orientation and the [110] orientation, which were orthogonal to each other, was recognized.

In order to measure the defect density of the resultant 3C-SiC substrate, the 3C-SiC substrate was immersed into a molten KOH solution of 500°C for 5 minutes. Afterwards, the substrate, in the surface of which defects existed, was measured using an optical microscope, and the following results could be obtained.

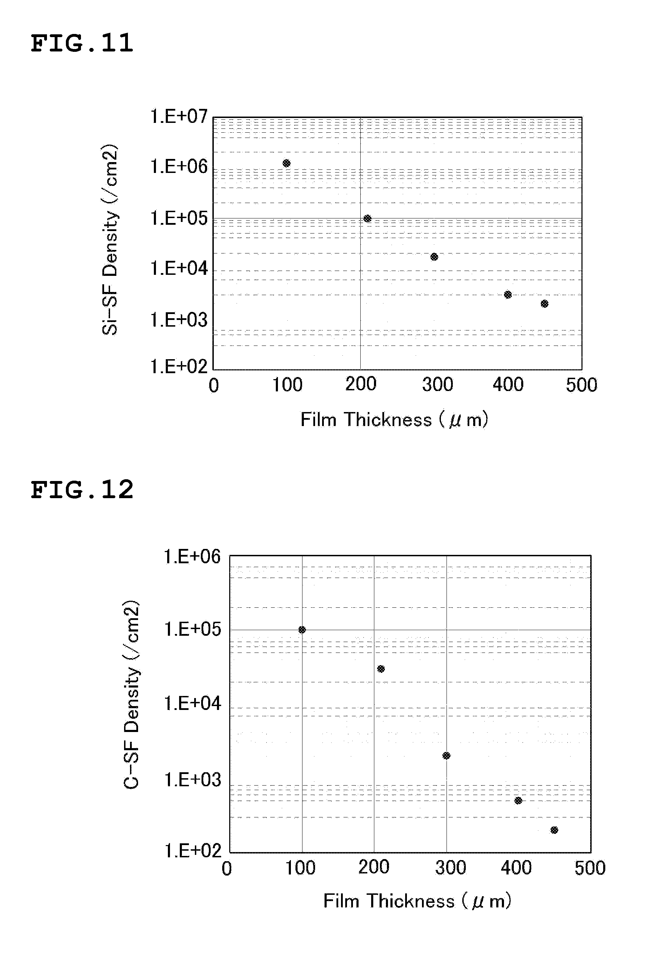

Fig. 11 shows the Si-SF density distribution in the cross-sectional direction, which was observed using an optical microscope. The Si-SF density decreased with the thickness of the SiC-grown film, and after the film was grown up to 450µm, the density on the top surface was 2×10³/cm². Fig. 12 shows the C-SF density distribution in the cross-sectional direction, which was observed using an optical microscope. The C-SF density decreases with the thickness of the SiC-grown film, and after the film was grown up to 450µm, the density on the top surface was 1×10²/cm² or less.

In addition, the APB was completely annihilated when the thickness of the SiC-grown film was in the range from 400µm to 450µm.

Although Example 1 has been described that the formation of the scratches in one direction using diamond slurry was performed as a method of forming the undulations over the Si substrate, the invention is not limited thereto. For example, it is possible to use a combination of a lithography process and an etching process. It is apparent that the same result can be obtained without using forming the undulations, if the arrangement or the cross-sectional configuration of the undulations is the same.

In addition, SiH₄, SiCl₄, SiHCl, and the like can be used as a Si source gas, for SiC growth. Likewise, CH₄, C₂H₆, C₃H₈, and the like can be used as a C source gas.

### (Comparative Example 1)

Undulations extending substantially in the [110] direction were formed over the entire surface of a Si (001) substrate having a diameter of 4 inches by rubbing polishing particles against the surface of the substrate to be parallel in the [110] direction. Diamond slurry (Hyprez manufactured by Engis Corporation) having a particle diameter of about 9µm was used as a polishing agent and was uniformly infiltrated into an polishing cloth (Engis M414) . The Si (001) substrate was placed on a pad, and the cloth was reciprocated at a distance of about 10nm about 300 times to be parallel in the [110] orientation while a pressure of 0.2kg/cm² was being applied across the Si (001) substrate (polishing in one direction). Thereby, the Si (001) substrate was covered with polishing scratches (undulations) substantially parallel in the [110] direction. The schematic view of the surface of the substrate to which the polishing scratches were introduced was the same as in Fig. 1.

Since diamond particles or the like were attached to the surface of the Si (001) substrate to which the polishing process was performed to be substantially parallel in the [110] orientation, the substrate was cleaned using an ultrasonic cleaner, followed by cleaning using a mixed solution of hydrogen peroxide solution and sulfuric acid, and a hydrofluoric acid. After the cleaning, a thermal oxide film of about 0.5µm was formed over the substrate, to which the undulation process was performed, using a thermal oxidation system. The formed thermal oxide film was removed using diluted hydrofluoric acid. The cross section of the area of the undulations, produced through this sacrificial oxidation treatment, was in the form of continued and very smooth wave , and the parallel undulations in the [110] orientation were always continuity. The ridge-valley height of the undulations was about 30nm to 50nm, the period of the undulations was about 1µm to 2µm, and the angle of inclination of the slopes of the undulations was about 3° to 5°.

An ultra-thin SiC layer was formed over the Si (001) substrate, which was produced as above, in the same way as in Example 1 . The ramping up conditions was the same as in Example 1.

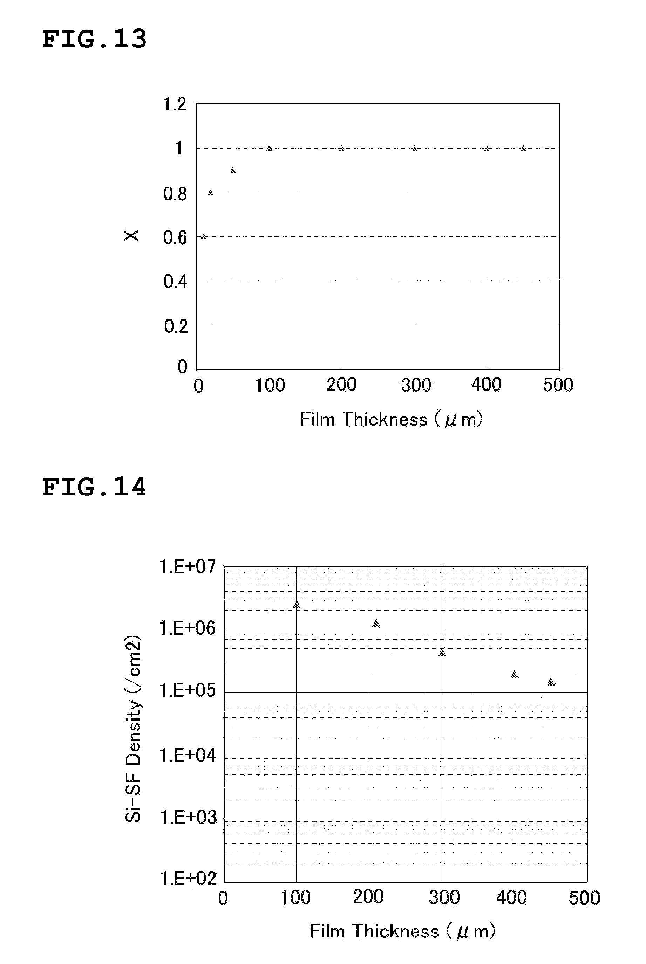

Afterwards, a SiC layer of 450µm was grown over the Si substrate in the same way as in Example 1, and the Si substrate was removed through eching in the same way as in Example 1. Thereby, a single 3C-SiC substrate was fabricated. Fig. 13 shows the dependence of x values on the thickness of the grown film in Comparative Example 1.

The shape of the resultant 3C-SiC substrate was measured, in which the radius of curvature in the direction parallel to the [-110] orientation was about 0.5m and that in the direction parallel to the [110] orientation was about 10m. That is, in the 3C-SiC substrate produced in Comparative Example 1, the anisotropy of the direction of the radius of curvature between the [-110] orientation and the [110] orientation, which were orthogonal to each other, was recognized. In addition, the degree of warpage was increased compared to that of Example 1.

In order to measure the defect density of the resultant 3C-SiC substrate, the 3C-SiC substrate was immersed into a molten KOH solution of 500°C for 5 minutes. Afterwards, the substrate, in the surface of which defects existed, was measured using an optical microscope, and the following results could be obtained.

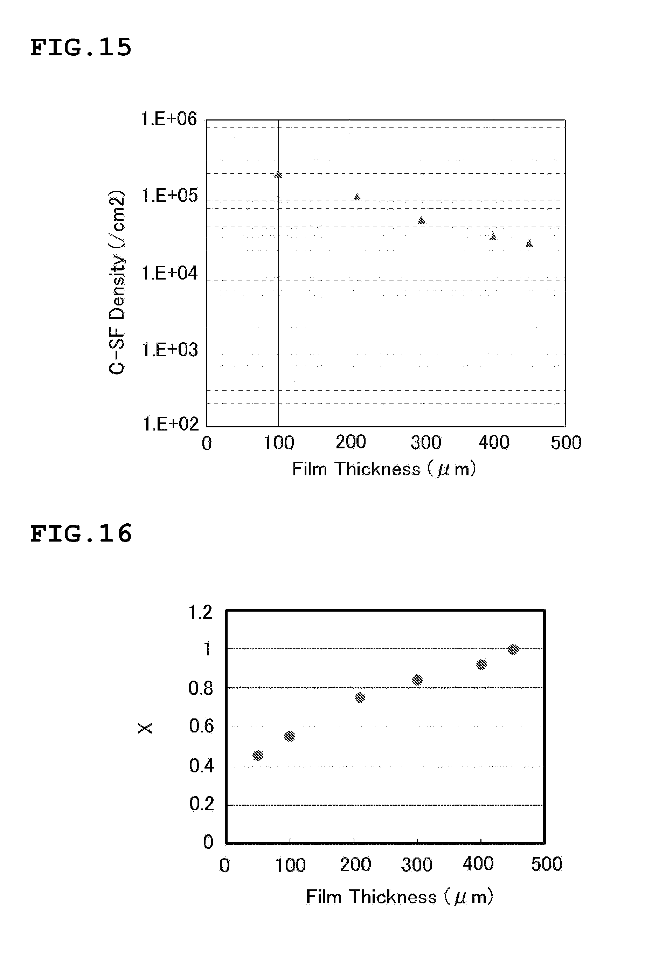

Fig. 14 shows Si-SF density distribution in the cross-sectional direction, which was observed using an optical microscope. Although the Si-SF density decreases with the thickness of the SiC-grown film, the decreasing rate is low, and after the film was grown up to 450µm, the density on the top surface was 1.5×10⁵/ cm². Fig. 15 shows C-SF density distribution in the cross-sectional direction, which was observed using an optical microscope. Although the C-SF density decreases with the thickness of the SiC-grown film, the decreasing rate is low, and after the film was grown up to 450µm, the density of the surface was 2.5×10⁴/cm². A number of C-SFs remained compared to Example 1. This is thought that new C-SFs were generated due to strain during the growth of SiC.

In addition, the APB was substantially annihilated when the thickness of the SiC-grown film was 100µm or less.

### (Example 2)

An ultra-thin SiC layer was formed by heating a Si (001) substrate having a diameter of 4 inches inside a CVD system in a mixed atmosphere of acetylene and hydrogen. Here, the substrate was heated up to 1350°C. A source gas, acetylene, and a carrier gas, hydrogen, were supplied to the surface of the substrate from room temperature. The amounts supplied and the pressure are the same as in Table 1.

After the surface temperature reached 1350°C, the temperature was kept in the atmosphere of Table 1 for 15 minutes. After the ultra-thin SiC layer was formed as above, the SiC layer was grown by supplying dichlorosilane, acetylene, and hydrogen at a temperature of 1350°C. 3C-SiC of 50µm was grown over the Si substrate by setting the SiC growth conditions to be the conditions in the 1^{st} stage in Table 3. If the flow rate of acetylene is relatively high as in these growth conditions, the APB is likely to remain since the aligning orientation of the polar face are difficult to set to a specific orientation.

**[Table 3]**

| SiC growth conditions in Example 2 | | | | |
|---|---|---|---|---|
| | Amount of Si₂H₂Cl₂ supplied | Amount of C₂H₂ supplied | Amount of H₂ supplied | Pressure |
| 1^{st} stage | 50cc/min | 50cc/min | 100cc/min | 50Pa |
| 2^{nd} stage | 50cc/min | 40cc/min | 100cc/min | 46Pa |
| 3^{rd} stage | 50cc/min | 30cc/min | 100cc/min | 44Pa |
| 4^{th} stage | 50cc/min | 20cc/min | 100cc/min | 42Pa |
| 5^{th} stage | 50cc/min | 10cc/min | 100cc/min | 40Pa |

Undulations extending substantially in the [110] direction were formed over the entire surface of the substrate by rubbing polishing particles against the resultant 3C-SiC film to be parallel in the [110] orientation when the surface of the substrate is set to be the (001) plane. Diamond slurry (Hyprez manufactured by Engis Corporation) having a particle diameter of about 9µm was used as a polishing agent and was uniformly infiltrated into a polishing cloth (Engis M414). The Si (001) substrate in which the 3C-SiC layer was formed was placed on a pad, and the cloth was reciprocated at a distance of about 10nm about 300 times to be parallel in the [110] direction while a pressure of 0.2kg/cm² was being applied across the Si (001) layer (polishing in one direction) . Thereby, the surface of the 3C-SiC layer was covered with polishing scratches (undulations), which were substantially parallel in the [110] orientation. The schematic view of the surface of the substrate to which the polishing scratches were introduced was the same as in Fig. 1.

Since diamonod particles or the like were attached to the surface of the 3C-SiC layer of the Si (001) substrate to which the polishing process was performed to be substantially parallel in the [110] direction, the substrate was cleaned using an ultrasonic cleaner, followed by cleaning using a mixed solution of hydrogen peroxide solution and sulfuric acid (1:1), and a hydrofluoric acid. After the cleaning, a thermal oxide film of about 0.5µm was formed over the substrate, to which the undulation process was performed, using a thrmal oxidation system. The formed thermal oxide film was removed using diluted hydrofluoric acid. The cross section of the area having the undulations, produced through this sacrificial oxidation treatment, was in the form of continued and very smooth waves, and the parallel undulations in the [110] orientation were always continuity. The ridge-valley height of the undulations was about 30nm to 50nm, the period of the undulations was about 1µm to 2µm, and the angle of inclination of the slopes of the undulations was about 3° to 5°.

An ultra-thin SiC layer was formed over 3C-Sic layer in the Si (001) substrate, which was produced as above, in the same way as in Example 1. The ramping up conditions is the same as in Example 1.

Afterwards, SiC was grown under the growth conditions of Table 3. A SiC layer of about 450µm was grown by fixing the amount of dichlorosilane supplied to 50sccm, fixing the amount of hydrogen supplied to 10sccm, and varying the amount of acetylene from 50sccm to 10sccm, continuously in five stages. The growth temperature was 1350°C, and the growth time was about 8 hours. If a flow rate of acetylene is relatively high as in the initial growth conditions in Table 3, it becomes difficult to determine the aligning orientation of the polar face to a specific orientation, and thus the APB is likely to remain. In the meantime, if the flow rate of acetylene is relatively low as in the latter growth conditions in Table 3, the aligning orientation of the polar plane are limited to a specific orientation, and thus the APB is annihilated. That is, it becomes possible to form the inclination of the density of the stacking fault in cross section, in which the film grows, by gradually varying the flow rate of acetylene from a higher value to a lower value. In this example, as the inclination is directed toward the top surface from the inside of the crystal, the APB density gradually decreases, and the APB on the top surface is completely removed.

The shape of the resultant 3C-SiC substrate was measured, in which the radius of curvature in the direction parallel to the [-110] orientation was about 22m and that in the direction parallel to the [110] orientation was about 25m. That is, in the 3C-SiC substrate produced in Example 2, no difference in the radii of curvature between the [-110] orientation and the [110] orientation, which were orthogonal to each other, was recognized.

In order to measure the defect density of the resultant 3C-SiC substrate, the 3C-SiC substrate was immersed into a molten KOH solution of 500°C for 5 minutes. Afterwards, the substrate, in the surface of which defects existed, was measured using an optical microscope. In the surface after the growth up to 450µm, the Si-SF density was about 4×10³/cm², and the C-SF density was about 2×10²/cm².

In addition, the APB was completely annihilated when the thickness of the SiC-grown film was in the range from 400µm to 450µm.

In Example 2, the SiC film growth is performed two times. Here, according to the growth conditions in first film growth, it is preferable to set the flow rate of C source, acetylene, to be relatively high in consideration that the APB remains. In addition, according to the growth conditions in second film growth, it is preferable to gradually vary the flow rate of acetylene, from a higher value to a lower value in consideration that the inclination of the defect density (APB, SF) is formed in the direction of film growth (that is, the direction of a cross section)

### (Example 3)

A 3C-SiC substrate was produced under the same conditions and operations as in Example 1, excepting that the film-forming conditions in from Table 2 were replaced with those of Table 3.

Fig. 16 shows the dependence of x values on the thickness of the grown film in Example 3. Compared to Fig. 10 (Example 1), the inclination of the variation of x values to the thickness of the grown film is uniform, and the APB remains even in the vicinity of the top surface. As the result of the residual APB obstructing the propagation of the Si-SF, it was confirmed that the Si-SF density decreases more than in Example 1. In the case of Example 3, on the top surface after the growth up to 450µm, the Si-SF density was about 1×10³/cm² or less, and the C-SF density was 1×10²/cm² or less.

As set forth above, according to the invention, it is possible to remove lattice strain or anisotropy inside a crystal by intentionally arranging APB inside the crystal, and thus produce a compound crystal surface from which warpage and SF are effectively reduced.

## Claims

1. A method for producing a compound single crystal composed of two types of elements, which include element A and element B, wherein the compound single crystal is epitaxially grown over a single crystal substrate having a cubic {001} plane as a surface thereof, the method comprising:
a process (I) of growing the compound single crystal while causing a stacking fault to equivalently occur in a <110> direction parallel to the surface, the stacking fault being attributable to an anti-phase boundary and the elements A and B;
a process (II) of merging and annihilating the stacking fault, which occur in the process (I), attributable to the element A, and the anti-phase boundary;
a process (III) of vanishing the stacking fault, which occurs in the process (I), attributable to the element B; and
a process (IV) of completely merging and annihilating the anti-phase boundary,
wherein the process (IV) is carried out simultaneously with the processes (II) and (III) or after the processes (II) and (III).

2. The method for producing a compound single crystal according to claim 1, wherein the process (I) epitaxially grows the compound single crystal over the single crystal substrate, wherein the single crystal substrate is a substrate that has, over a surface thereof, a region in which a plurality of undulations extending in parallel in a [110] direction is formed, and a region, in which a plurality of undulations extending in parallel in [-110] direction is formed, wherein both side surfaces of the undulations have a slope-shape.

3. The method for producing a compound single crystal according to claim 2, wherein the processes (II) and (III) are an epitaxial growth process over the undulations.

4. The method for producing a compound single crystal according to claim 2 or 3, wherein the process (IV) preferentially grows the undulations in a direction parallel or orthogonal to the extending direction thereof in each of the regions, by varying a source ratio of the elements A and B.

5. The method for producing a compound single crystal according to claim 1, wherein the processes (I), (II) and (III) are an epitaxial growth process over an unprocessed {001} plane,
wherein the process (IV) forms a plurality of undulations that extends in parallel in a [110] direction on a surface that is obtained in the processes (I) to (III), both side surfaces of the undulation having slope-shape, and epitaxially grows the compound single crystal over the undulations.

6. A method for producing a compound single crystal, in which the compound single crystal is epitaxially grown over a single crystal substrate having a cubic {001} plane as a surface thereof, the method comprising:
a process of alternately preparing a region A and a region B over an entire surface of an effective area of the substrate, wherein the region A is formed with a plurality of undulations extending in parallel in one direction, and the region B is formed with a plurality of undulations extending in a direction orthogonal to the extending direction thereof; and
a process of epitaxially growing the compound single crystal over the substrate having the region A and the region B,
wherein both side surfaces of the undulations have a slope shape.

7. The method for producing a compound single crystal according to claim 6, wherein the process of epitaxially growing comprises a process of preferentially growing the undulations in a direction parallel or orthogonal to the extending direction thereof in each of the regions by varying a source ratio.

8. The method for producing a compound single crystal according to claim 6 or 7, wherein the region A has a surface area that is substantially equal to that of the region B in a surface of the substrate.

9. A method for producing a compound single crystal, wherein the compound single crystal is epitaxially grown over a single crystal substrate having a cubic {001} plane as a surface thereof, the method comprising:
a process of epitaxially growing the compound single crystal over an unprocessed {001} plane as the substrate;
a process of forming a plurality of undulations that extends in parallel in a [110] direction on a surface of the compound single crystal obtained in the epitaxial growth process; and
a process of epitaxial growth of a compound single crystal over the undulations.

10. The method for producing a compound single crystal according to any one of claim 2 to 9, wherein the undulations are formed such that an angle defining with the substrate is from 2° to 55° and slopes of the undulations are opposite each other.

11. The method for producing a compound single crystal according to any one of claim 1 to 10, wherein the stacking fault remaining on the {001} plane, which is the top surface, has a single polarity, and substantially equivalently exists in the <110> direction on an entire surface of the {001} plane.

12. The method for producing a compound single crystal according to any one of claim 1 to 11, wherein the substrate is a cubic Si substrate or a cubic SiC substrate, and the compound single crystal is a cubic SiC crystal.

13. A compound single crystal composed of two types of elements, which include element A and element B, comprising two types of crystal growth regions,
wherein the two types of crystal growth regions are formed alternately for each type, in a direction orthogonal to a crystal growth direction,
wherein a stacking fault A-SF, at which the polarity of the element A exposes, and a stacking fault B-SF, at which the polarity of the element B exposes, exist inside the crystal,
wherein only the fault A-SF of the faults exists on a specific {001} plane, and the fault A-SF on the specific {001} plane exists extending in a <110> direction over an entire surface of the {001} plane, the fault A-SF being statistically equivalent,
wherein, in the two types of crystal growth regions, propagation orientations of the two types of the stacking faults are limited to different planes in each of the crystal growth regions,
wherein the propagation orientation of a planar defect in one of the crystal growth regions is an orientation that is produced by orthogonally converting the propagation orientation of the two types of the stacking faults in the other one of the crystal growth regions while maintaining the propagation orientation parallel to the specific {001} plane,
wherein, in a cross section of a portion defined by the two types of crystal growth regions in a direction, in which the two types of crystal growth regions are formed alternately, no anti-phase boundaries (APBs) appear in one of the crystal growth regions and APBs appear or are merged and annihilated in the other one of the crystal growth regions, and
wherein APBs are annihilated on the top surface of the crystal.

14. The compound single crystal according to claim 13, wherein the compound crystal is cubic, with the bottom surface thereof being a (001) plane,
wherein the two types of crystal regions are formed alternately for each type, toward at least one of a [110] orientation and a [-110] orientation,
wherein polar sections in the top surface of the compound crystal are formed in a direction that alternates with the [110] orientation and the [-110] orientation in each of the two types of crystal growth regions, and
an area ratio between the two types of crystal growth regions in the surface of the compound crystal is 3:7 to 7:3.

15. A compound single crystal composed of two types of elements, which include element A and element B,
wherein a stacking fault A-SF, at which the polarity of the element A exposes, a stacking fault B-SF, at which the polarity of the element B exposes, and an anti-phase boundary (APB) exist inside the crystal,
wherein all APB are merged and annihilated, and
wherein only the fault A-SF of the faults exists in a specific {001} plane, and the fault A-SF on the specific {001} plane exists extending in a <110> direction over an entire surface of the {001} plane, the fault A-SF being statistically equivalent.

16. The compound single crystal according to claim 13 to 15, wherein the compound crystal is cubic silicon carbide.

17. The compound single crystal according to claim 16, wherein the element A is silicon, and the element B is carbon.

18. The compound single crystal according to claim 13, the compound single crystal having a film or plate-like configuration, a degree of warpage in the {001} plane is substantially equal in the <110> direction inside the plane.
